# DEMANDE DE BREVET EUROPEEN

(11) **EP 0 887 653 A1**
(43) Date de publication de la demande: **30.12.1998**
(21) Numéro de dépôt: 98410071.9
(22) Date de dépôt: 22.06.1998
(51) Int. Cl.: G01R 31/3185

(54) **Procédé de test fonctionnel et circuit comprenant des moyens de mise en oeuvre du procédé**

(30) Priorité: 24.06.1997 FR 9708166
(71) Demandeur: SGS-THOMSON MICROELECTRONICS S.A., 94250 Gentilly (FR)
(72) Inventeur: Frey, Christophe, 38240 Meylan (FR); Hanriat, Stéphane, 38660 Saint Vincent de Mercuze (FR)
(74) Mandataire: de Beaumont, Michel

(57) **Abrégé**

L'invention concerne un procédé de test fonctionnel de circuit logique (2) et un circuit intégré (1) apte à le mettre en oeuvre.

Le procédé comprend :
- la fourniture d'au moins un motif de test et le stockage de ce motif de test dans un registre de test (4), ladite fourniture étant synchronisée par un signal d'horloge externe (TCK),
- la foumiture en série de ce motif de test à une entrée (IN) du circuit logique interne, ladite fourniture étant synchronisée par un signal d'horloge de test (LCCK) produit à partir d'un signal d'horloge interne (CKFAST),
- le stockage, dans un deuxième registre de test (6) relié à la sortie (OUT) du circuit logique interne, d'au moins un motif résultant produit par le circuit logique interne quand on lui fournit le motif de test, ledit stockage étant synchronisé par le signal d'horloge de test, et
- la fourniture vers l'extérieur, par décalage en série, du motif résultant, ladite fourniture étant synchronisée par le signal d'horloge externe (TCK).

## Description

L'invention concerne le domaine du test fonctionnel des circuits intégrés logiques ou comprenant des parties logiques.

La production de circuits intégrés comprend généralement des étapes de test des circuits fabriqués. La fabrication peut elle-même être, éventuellement, destinée à des fins de test, quand il s'agit de valider un nouveau circuit ou de transférer la fabrication d'un circuit d'une technologie éprouvée vers une nouvelle technologie.

Ces tests sont habituellement de deux types : les tests structurels, d'une part, et les tests fonctionnels, d'autre part. Les tests structurels ont pour objet de vérifier que les circuits ne présentent pas de défauts physiques les rendant inopérants, ces défauts étant indépendants des applications des circuits. Les tests fonctionnels ont pour objet de vérifier, pour les circuits ne présentant pas de défauts physiques, que ces circuits fonctionnent correctement pour les applications auxquelles ils sont destinés.

Ces tests, généralement pilotés par des machines de test automatiques, peuvent être réalisés avant encapsulation, par le biais de sondes permettant d'accéder aux plots d'accès du circuit. Ils peuvent également être réalisés après encapsulation, en accédant au circuit par le biais de ses broches d'accès.

Une méthode pour mettre en oeuvre les tests fonctionnels est d'envoyer des signaux logiques sur les entrées (plots ou broches) du circuit à tester, d'observer les états des signaux fournis sur ses sorties (plots ou broches) et de comparer ces états avec les états théoriquement attendus. Les états des signaux logiques fournis forment ce qu'on appelle, habituellement, des motifs ou vecteurs de test.

Comme on cherche de plus en plus à diminuer la surface des circuits tout en augmentant l'intégration des circuits et leur fréquence de fonctionnement, cette méthode a plusieurs inconvénients.

Tout d'abord, en pratique, le nombre d'entrées et de sorties des circuits n'augmente pas proportionnellement à la complexité grandissante de ces circuits. La diminution des résolutions minimales de fabrication permet de disposer de circuits de plus en plus complexes, à surface égale, alors que le nombre de plots augmente peu. En effet, ce nombre de plots est fonction du type de boîtier dans lequel doit être inséré le circuit. Or, la taille des broches doit être suffisamment importante pour permettre d'assurer un soudage fiable de ses broches et, proportionnellement, cette taille diminue moins vite que les résolutions minimales de fabrication. Comme, par ailleurs, on souhaite généralement limiter la surface des circuits, cela se traduit par un accroissement du nombre de circuits internes non accessibles directement depuis l'extérieur des circuits. Il se pose donc, lors des tests, un problème d'accès aux éléments internes des circuits. Cela est d'autant plus vrai pour les circuit comprenant, par exemple, des processeurs internes mettant en oeuvre des périphériques sans relation avec l'extérieur, tels que des mémoires de programmes ou des mémoires dynamiques. On peut mettre en oeuvre des dispositifs de test mixtes, réalisés à l'aide de registres à décalage, internes, disposés sur les bus internes des circuits et pilotés par des appareils de test externes. De la sorte, on obtient une meilleure observabilité des dispositifs internes des circuits. En effet, on peut fournir un nombre de signaux de test plus important, à nombre d'entrées et de sorties égal, en utilisant des entrées et sorties série pour fournir un à un les vecteurs de test et recevoir les états des signaux résultants de leur prise en compte par le circuit (ces états résultants seront appelés par la suite vecteurs résultants). Par contre, cela se fait au détriment de la durée des tests puisqu'il est nécessaire, pour chaque étape de test, de fournir en série un vecteur de test, et de recevoir en série le vecteur résultant. De plus, on ne peut mettre en oeuvre un test qu'étape par étape, ce qui est peu représentatif du fonctionnement final du circuit testé.

Un autre problème provient de la volonté de disposer de circuits de plus en plus performants en terme de fréquence de fonctionnement. En effet, pour que leurs résultats soient représentatifs, les tests doivent être réalisés dans des conditions de fonctionnement normales. Cela revient, en pratique, à utiliser des appareils de test à large bande passante, aptes à fournir et à échantillonner des signaux aux fréquences de fonctionnement des circuits, ces fréquences pouvant atteindre plusieurs centaines de mégahertz. Cela pose des problèmes de réalisation des appareils de test, par exemple au niveau des sondes permettant d'accéder aux plots ou broches des circuits.

Un autre problème provient de la présence éventuelle de circuits internes fonctionnant à une fréquence de fonctionnement supérieure à celle des circuits internes d'interface avec l'extérieur. Les circuits internes d'interface sont, généralement, dimensionnés par rapport aux charges qu'ils doivent supporter sur les plots ou broches d'entrée et de sortie. On a tendance à utiliser des circuits tampons, aptes à fournir des courants importants mais dont les performances, en terme de fréquence de fonctionnement, sont limitées, sous peine de devoir supporter une consommations très importante. Par contre, pour réaliser les circuits internes logiques, on peut utiliser des fréquences plus importantes, les charges supportées par ces circuits étant généralement faibles. Si cela est le cas, on pourra difficilement tester ces circuits logiques puisque, même si on peut accéder à ces circuits par le biais des plots ou broches, on sera limité en fréquence par les circuits d'interface.

Une solution à ces problèmes est d'utiliser des dispositifs automatiques de test embarqués dans les circuits pour réaliser les tests fonctionnels, et commandés par des programmes eux aussi embarqués.

Un premier problème posé par ce type de solution est la surface occupée par ces ressources internes de test. Cette surface est occupée au détriment de la surface occupée par les circuits réellement mis en oeuvre dans les applications, ce qui limite la surface fonctionnelle utile des circuits, et ce d'autant plus que les tests sont plus complexes.

On peut, éventuellement, limiter la surface de ces dispositifs en utilisant, lors des tests, des ressources utilisées ultérieurement dans les applications. Par exemple, pour les circuits comprenant un processeur interne, on pourra simplement prévoir une mémoire supplémentaire comprenant un programme de test mis en oeuvre par ce processeur. Un problème est alors d'assurer une couverture de test satisfaisante, notamment pour les ressources internes utilisées pour mettre en oeuvre le programme de test. Dans la mise en oeuvre des tests, cela peut également poser des problèmes en terme de contrôle, tels que l'impossibilité de pouvoir agir sur le circuit testé si un blocage se produit à l'intérieur du circuit testé.

D'autre part, de tels dispositifs intégrés n'offrent pas une flexibilité analogue à celle offerte par les appareils externes, dans la mise en oeuvre des tests. Par exemple, modifier un programme de test peut obliger à modifier le circuit, à moins de disposer d'une mémoire accessible de l'extérieur, ce qui ne se justifie pas si cette mémoire est utilisée uniquement pour le test.

Un but de l'invention est de proposer un procédé de test de circuits intégrés amélioré, qui permette de s'affranchir du problème de bande passante lié aux appareils de test et aux circuits d'interface internes.

Un autre but de l'invention est de proposer un procédé de test qui donne une bonne observabilité du fonctionnement interne des circuits testés.

Un autre but de l'invention est de proposer un procédé qui ne nécessite pas de dispositifs internes utilisant une surface importante du circuit à tester.

Un autre but de l'invention est de proposer un procédé qui offre des possibilités étendues en matière de test.

Ainsi, l'invention propose un procédé de test fonctionnel d'un circuit intégré comprenant au moins un circuit logique interne à tester, ce circuit logique interne comprenant au moins une entrée et une sortie. Le procédé comprend :
- la fourniture d'au moins un motif de test formé d'un ensemble d'états logiques sur une première entrée du circuit intégré, par décalage en série, et stockage de ce motif de test dans un premier registre de test, ladite fourniture étant synchronisée par un signal d'horloge externe reçu sur une deuxième entrée du circuit intégré,
- la fourniture en série de ce motif de test à l'entrée du circuit logique interne, ladite fourniture étant synchronisée par un signal d'horloge de test produit à partir d'un signal d'horloge interne produit dans le circuit intégré, ledit premier signal d'horloge interne ayant une fréquence supérieure à la fréquence du signal d'horloge externe,
- le stockage, dans un deuxième registre de test relié à la sortie du circuit logique interne, d'au moins un motif résultant produit par le circuit logique interne quand on lui fournit le motif de test, ledit stockage étant synchronisé par le signal d'horloge de test, et
- la fourniture, par décalage en série, sur une première sortie du circuit intégré, du motif résultant, ladite fourniture étant synchronisée par le signal d'horloge externe.

Selon un mode de réalisation, le signal d'horloge interne est produit par un oscillateur en anneau programmable.

Selon un mode de réalisation, la fourniture du motif de test au circuit logique interne est réalisée par le biais d'un circuit de conversion parallèle/série, de sorte que l'on puisse fournir plusieurs fois ce motif de test au circuit logique interne, une fois ce motif stocké dans le premier registre de test.

Selon un mode de réalisation, le signal d'horloge de test est produit par filtrage temporel du signal d'horloge interne, de sorte que le fonctionnement du circuit logique interne soit limité temporellement à la durée nécessaire pour qu'il reçoive le motif de test et qu'il produise le motif résultant.

Selon un mode de réalisation, le circuit de conversion parallèle/série est piloté par des signaux de commande dont la production est synchronisée avec la production du signal d'horloge de test, ces signaux de commande et d'horloge de test étant fournis au circuit de conversion parallèle/série et au circuit logique interne par le biais de circuits de déphasage programmables, de sorte que l'on puisse introduire un déphasage temporel entre les signaux de commande et le signal d'horloge de test.

L'invention concerne également un circuit intégré comprenant un circuit logique interne et des moyens de test pour tester le fonctionnement dudit circuit logique interne, ledit circuit logique interne comprenant une entrée et une sortie.

Les moyens de test comprennent :
- un premier registre de test ayant une entrée reliée à une première entrée du circuit intégré et au moins une sortie reliée à l'entrée du circuit logique interne,
- un deuxième registre de test ayant une entrée reliée à la sortie du circuit logique interne et une sortie reliée à une première sortie du circuit intégré,
- une deuxième entrée pour recevoir un signal d'horloge externe pour piloter, d'une part, la fourniture au premier registre de test d'au moins un motif de test reçu sur la première entrée, ledit motif étant formé d'un ensemble d'états logiques et, d'autre part, la fourniture à la première sortie d'au moins un motif résultant mémorisé dans le deuxième registre de test, ce motif résultant étant produit sur la sortie du circuit logique interne quand on fournit le motif de test à l'entrée dudit circuit logique interne,
- un circuit générateur de signal d'horloge pour produire un signal d'horloge interne, et
- un circuit de contrôle pour produire, à partir du signal d'horloge interne, un signal d'horloge de test permettant de piloter la fourniture du motif de test à l'entrée du circuit logique interne et la fourniture du motif résultant à l'entrée du deuxième registre de test.

Selon un mode de réalisation, le circuit comprend une deuxième sortie et les moyens de test comprennent un circuit diviseur de fréquence recevant le signal d'horloge interne et produisant un signal d'horloge interne dérivé, de fréquence inférieure à celle du signal d'horloge interne, ladite fréquence inférieure étant représentative de la fréquence du signal d'horloge interne, et ledit signal d'horloge interne dérivé étant fourni à la deuxième sortie du circuit intégré.

Selon un mode de réalisation, le circuit générateur de signal d'horloge comprend un premier circuit de retard programmable pour produire un retard programmable et des circuits logiques permettant de réaliser un oscillateur en anneau programmable par rebouclage d'une entrée et d'une sortie du premier circuit à retard.

Selon un mode de réalisation, le premier circuit à retard du circuit générateur de signal d'horloge produit un signal carré de fréquence programmable et le circuit générateur de signal d'horloge comprend un deuxième circuit de retard programmable recevant le signal carré et produisant un signal carré retardé, une porte logique produisant un signal d'horloge intermédiaire à partir d'une combinaison du signal carré et du signal carré retardé, de sorte que le signal intermédiaire a un rapport cyclique programmable, et des moyens pour produire le signal d'horloge interne à partir du signal d'horloge intermédiaire.

Selon un mode de réalisation, le circuit comprend un circuit de conversion parallèle/série placé entre le premier registre de test et l'entrée du circuit logique interne et le circuit de contrôle produit un ou des signaux de sélection pour piloter le circuit de conversion parallèle/série, lesdits signaux de sélection étant produits à partir du signal d'horloge interne.

Selon un mode de réalisation, le circuit de contrôle comprend, d'une part, un circuit de production de signaux de pilotage pour produire un signal d'horloge filtré et des signaux de sélection primaires et, d'autre part, des circuits de déphasage recevant le signal d'horloge filtré et les signaux de sélection primaires, ces circuits de déphasage comprenant des circuits à retard programmables pour produire, à partir des signaux reçus, les signaux de sélection pilotant le circuit de conversion parallèle/série et le signal d'horloge de test, lesdits signaux de sélection pilotant le circuit de conversion parallèle/série étant déphasés temporellement par rapport au signal d'horloge de test.

Selon un mode de réalisation, le circuit de contrôle comprend des moyens de filtrage pour produire, à partir du signal d'horloge interne, dans un mode de test dit en rafale, le signal d'horloge de test pilotant le fonctionnement du circuit logique interne, ce signal d'horloge de test comprenant au moins un train d'impulsions comprenant un nombre d'impulsions déterminé.

Selon un mode de réalisation, le circuit de contrôle fournit un signal logique représentatif de la durée de trains d'impulsions dans le mode de test en rafale.

Dans l'invention, on prévoit d'utiliser un appareil de test externe pour mettre en oeuvre le test, ce qui permet de s'affranchir des problèmes liés à l'utilisation de tests par des dispositifs de test internes. Pour pallier au problème de la bande passante des appareils de test et des circuits d'interface, on prévoit de réaliser les échanges de données, entre l'appareil de test et le circuit à tester, à une fréquence compatible avec les fréquences de fonctionnement normales de l'appareil de test et des circuits d'interface du circuit à tester. On réalise le test proprement dit dans des conditions comparables, en terme de fréquence et de déroulement, aux conditions de fonctionnement normal du circuit testé, ce qui permet d'obtenir des résultats de test représentatifs de ce fonctionnement normal.

D'autres avantages et particularités apparaîtront à la lecture de la description qui suit d'un exemple de réalisation de l'invention, à lire conjointement aux dessins annexés dans lesquels :
- la figure 1 illustre un exemple de circuit mettant en oeuvre l'invention,
- la figure 2 illustre un exemple plus détaillé d'éléments de contrôle du circuit de la figure 1,
- la figure 3 illustre un circuit de retard permettant de réaliser un oscillateur en anneau programmable,
- la figure 4 illustre un circuit à retard formé de deux circuits semblables à celui de la figure 3,
- la figure 5 illustre un circuit générateur de signal d'horloge programmable permettant de produire un signal d'horloge interne,
- la figure 6 représente un chronogramme d'un signal d'horloge produit par le circuit de la figure 5,
- les figures 7a à 7f illustrent des chronogrammes de signaux produits et reçus par un circuit de production de signaux de pilotage,
- la figure 8 illustre un circuit de déphasage permettant d'introduire un déphasage entre des signaux logiques,
- les figures 9a et 9b illustrent des chronogrammes de signaux de donnée et d'horloge.

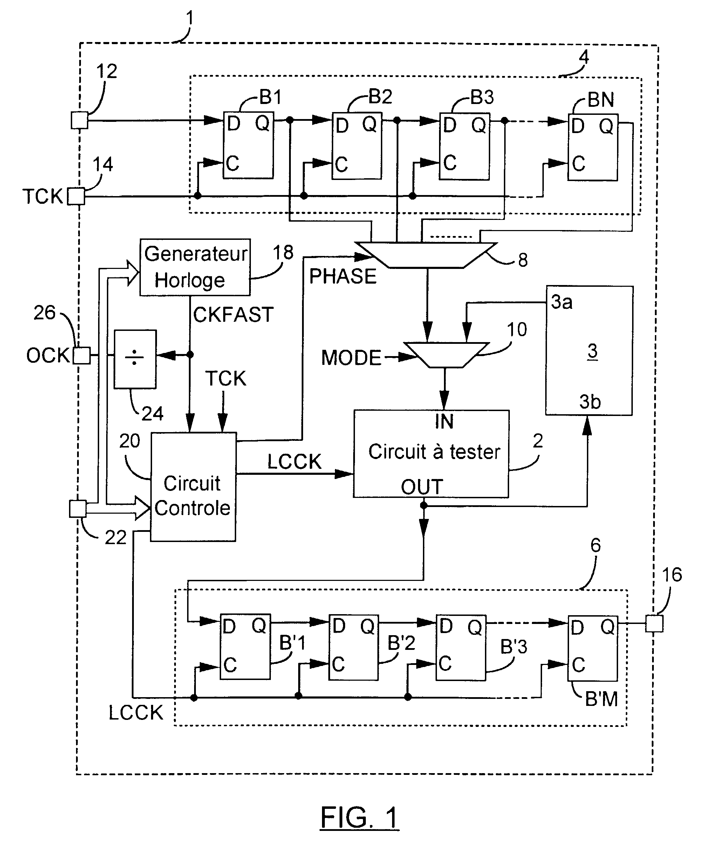

La figure 1 illustre un exemple schématique de circuit intégré 1 mettant en oeuvre le procédé de test fonctionnel selon l'invention.

Ce circuit intégré 1 comprend un circuit logique interne 2 à tester comprenant, dans l'exemple, une entrée IN et une sortie OUT. Le nombre d'entrées et de sorties du circuit 2 pourra bien entendu être plus important. Par ailleurs, le circuit 1 pourra comprendre d'autres circuits logiques internes.

Le circuit 1 pourra être un circuit - test, c'est-à-dire être réalisé dans un but de validation de conception et/ou de technologie. Ce pourra être également un circuit destiné à la vente, qui comprend certains circuits fonctionnant à une fréquence d'horloge interne rapide. Dans ce cas, le circuit 2 pourra être relié avec un ou plusieurs autres circuits internes au circuit 1. Ainsi, sur la figure 1, on a représenté un circuit 3 comprenant une entrée 3a et une sortie 3b de sorte qu'il puisse échanger des états logiques avec le circuit 2. Le circuit 2 pourra être, par exemple, une mémoire cache ayant une fréquence de fonctionnement plus rapide que la fréquence de fonctionnement d'autres éléments du circuit 1.

Le procédé de test comprend la fourniture, d'un appareil de test externe (non représenté) vers le circuit 1, d'un ou plusieurs motifs de test et la fourniture, du circuit 1 vers l'appareil de test d'un ou de plusieurs motifs résultants de l'application des vecteurs de test.

Par motif de test, on entend un ensemble d'états logiques qu'on applique à des entrées primaires du circuit 1. Par motif résultant, on entend un ensemble d'états logiques produits en interne dans le circuit 1 et fournis par des sorties primaires en réponse au ou aux motifs de test. Pour un circuit donné, les états logiques formant les motifs résultants sont comparés à des états logiques attendus, ces états logiques attendus étant calculés d'après les équations logiques du circuit et d'après l'ensemble des états fournis au circuit par l'appareil de test. Il y a succès si les états fournis par le circuit coïncident avec les états attendus.

Les motifs sont formés de vecteurs ou de parties de vecteurs. Par vecteur, on comprendra un signal logique (si le vecteur est de dimension 1) ou plusieurs signaux logiques (si le vecteur est de dimension supérieure) fournis ou reçus simultanément. Dans l'exemple décrit ci-dessous, on considérera des vecteurs de test et des vecteurs résultants de dimension 1, cette dimension correspondant aux nombres d'entrées et de sorties du circuit logique interne 2. Si on utilise P vecteurs de dimension K supérieure à 1, on utilisera K motifs de dimension P, chaque motif permettant de stocker un des K états des vecteurs.

Par entrées/sorties primaires d'un circuit, on entend les noeuds du circuit accessibles de l'extérieur de ce circuit, c'est-à-dire connectés directement à des plots d'accès. L'état de ces noeuds peut être contrôlé (c'est-à-dire imposé et/ou observé) directement par une machine de test soit au niveau de plots, avant encapsulation, soit au niveau de broches reliées à ces plots, après encapsulation.

Le procédé de test fonctionnel comprend les étapes suivantes :
- la fourniture en série, sur une entrée primaire du circuit 1, d'au moins un motif de test formé de N vecteurs de test, de dimension 1, à appliquer à l'entrée IN du circuit logique interne 2, et stockage de ces vecteurs dans un premier registre de test 4, ladite foumiture étant synchronisée par un signal d'horloge externe TCK de fréquence inférieure ou égale aux fréquences de fonctionnement maximales de l'appareil de test et des entrées/sorties du circuit 1, ledit signal d'horloge interne étant reçu sur une entrée primaire 14 du circuit 1,
- la fourniture en série de ces vecteurs de test à l'entrée IN du circuit interne logique 2, à une fréquence pouvant être supérieure ou égale à la fréquence de fonctionnement normale de ce circuit logique interne, ladite fourniture étant synchronisée par un signal d'horloge de test LCCK produit à partir d'un signal d'horloge interne CKFAST,
- le stockage, dans un deuxième registre de test 6, relié à la sortie OUT du circuit logique interne, d'un motif résultant formé de M vecteurs résultants, de dimension 1, apparaissants sur cette sortie OUT quand on fournit audit circuit logique les N vecteurs de test, ledit stockage étant synchronisé par le signal d'horloge de test, et
- la fourniture en série, sur une sortie primaire du circuit intégré, du motif résultant, ladite fourniture étant synchronisée par le signal d'horloge externe, c'est-à-dire à une fréquence inférieure ou égale aux fréquences de fonctionnement maximales de l'appareil de test et des entrées/sorties primaires du circuit 1.

Chaque vecteur de test est formé de un état logique, autrement dit du nombre d'états logiques à fournir simultanément au circuit 2 pour qu'il fonctionne. Chaque vecteur résultant est formé de un état logique, autrement dit du nombre d'états logiques produits simultanément par le circuit 2 lorsqu'il fonctionne.

Si le circuit interne logique comprend plusieurs entrées liées fonctionnellement, on utilisera des vecteurs de test dont la dimension correspond au nombre d'entrées. Ainsi, si le circuit 2 a deux entrées liées fonctionnellement, on utilisera deux registres pour mémoriser des vecteurs de test comprenant chacun deux états. L'un des registres mémorisera un premier motif de test formé par l'ensemble des premiers états des vecteurs et l'autre registre mémorisera un second motif de test formé par l'ensemble des seconds états des vecteurs. En test, les deux états de chaque vecteur seront fournis simultanément aux deux entrées du circuit 2.

De même, si ce circuit comprend plusieurs sorties liées fonctionnellement, la dimension des vecteurs résultants correspondra au nombre de sorties. On utilisera alors un banc de registres pour stocker les vecteurs résultants. Le nombre de registres et des motifs résultants qu'ils peuvent mémoriser correspondra, bien entendu, à la dimension des vecteurs résultants reçus.

Les premier et deuxième registres de test 4 et 6 sont formés, respectivement, de N bascules B1, B2, ..., BN montées en série, et de M bascules B'1, B'2, ..., B'M montées en série. Ces bascules comprennent une entrée de donnée D, une sortie de donnée Q et une entrée d'horloge C.

Le circuit 1 comprend un circuit de conversion parallèle/série disposé entre le premier registre de test 4 et le circuit logique interne 2 à tester. Il s'agit, dans l'exemple, d'un multiplexeur 8 comprenant N entrées, reliées aux sorties des bascules du registre 4, et une sortie. Il permet de fournir à l'entrée IN du circuit 2, successivement, N états des N vecteurs de test (les vecteurs étant de dimension 1, on confondra chaque vecteur avec l'état logique le formant). L'utilisation d'un circuit de conversion parallèle/série permet de maintenir les états (ou vecteurs de dimension 1) dans le registre 4 lorsque ces états sont fournis au circuit 2. De la sorte, il est possible de fournir plusieurs fois au circuit 2 les mêmes états ou vecteurs de test, sans qu'on ait à charger le registre 4 plusieurs fois. Si le circuit 2 est une mémoire, on pourra, par exemple, effectuer des tests de fiabilité en écrivant ou en lisant plusieurs fois de suite une même donnée à une même adresse. On pourra même modifier les états fournis au circuit 2 simplement en modifiant les signaux de commande du multiplexeur, ce qui équivaut à permuter les états dans le registre 4. On pourra aussi, si on considère l'utilisation de plusieurs registres de test en entrée, modifier les contenus d'une partie des registres sans avoir à modifier le contenu de tous les registres. On veillera alors, bien entendu, à ne pas chaîner tous ces registres quand on leur fournit des données, afin de pouvoir accéder de manière sélective à ces registres.

Selon la nature des tests envisagés, on pourra éventuellement ne pas utiliser de circuit de conversion parallèle/série. Il suffit alors de fournir en série les états formant le motif de test, par le biais de la sortie Q de la dernière bascule BN du registre de test 4. Cela permet de limiter la surface occupée par le circuit de test et, plus particulièrement, par le multiplexeur 8 et les lignes conductrices reliant ses entrées aux sorties des bascules.

Dans l'exemple, la sortie du multiplexeur 8 est relié à une entrée d'un multiplexeur 10 comprenant deux entrées et une sortie reliée à l'entrée IN du circuit 2. L'autre entrée du multiplexeur 10 est reliée à la sortie 3a du circuit 3 et il reçoit un signal de commande MODE. Un telle configuration permet, typiquement, de fournir le motif de test mémorisé dans le registre 4 à l'entrée IN quand on est en mode de test, et de relier l'entrée IN à la sortie 3a quand on est en fonctionnement normal. Typiquement, le signal MODE est un signal binaire dont l'état est représentatif du mode dans lequel on est. Il pourra être fourni, par exemple, par la machine de test externe, par le biais d'une entrée/sortie primaire du circuit 1.

La sortie OUT est reliée à l'entrée D de la première bascule B'1 du registre de sortie 6. Dans l'exemple illustré, la sortie OUT est également reliée à l'entrée 3b du circuit 3. Bien entendu, on pourra utiliser une sortie OUT dédiée au test, auquel cas elle ne sera reliée qu'à la bascule B'1. Ce qui importe, c'est que les états logiques fournis sur cette sortie OUT soient représentatifs du fonctionnement interne du circuit 2.

Le registre de test 6 et la sortie OUT du circuit 2 pourront éventuellement être reliés par le biais d'un démultiplexeur à une entrée et M sorties, de manière similaire à la connexion réalisée entre le registre de test 4 et l'entrée IN. Si cela aboutit à un encombrement plus important des ressources de test, cela permet, par exemple, d'utiliser des bascules dont la fréquence de fonctionnement peut être plus lente que celle du circuit logique 2, sans que cela empêche de mémoriser les états de sortie dans le registre 6. On notera que cet avantage est bien entendu partagé par les bascules du registre 4 qui sont connectées au circuit 2 par le biais du multiplexeur 8. Les multiplexeurs et démultiplexeurs étant réalisés classiquement à l'aide de portes logiques ou de commutateurs CMOS, on choisira bien entendu ces éléments de sorte qu'ils aient un temps de réponse compatible avec la fréquence de fonctionnement du circuit logique 2.

Le circuit 1 comprend une entrée primaire 12 permettant de fournir au registre 4, par décalage en série depuis l'extérieur, des états logiques. Cette entrée 12 est reliée à l'entrée D de la première bascule B1 du registre 4.

Le circuit 1 comprend également une entrée primaire 14 permettant de fournir le signal d'horloge externe TCK, produit à l'extérieur du circuit 1, aux entrées C des bascules du registre 4. Ce signal TCK a une fréquence compatible avec la bande passante de l'entrée 14 et, a fortiori, compatible avec le dispositif externe qui le fournit au circuit 1. Il permet de synchroniser le décalage d'états logiques dans les bascules du registre 4.

Le circuit 1 comprend également une sortie primaire 16, reliée à la sortie Q de la dernière bascule B'M du registre 6. Elle permet de transférer, par décalage en série, le contenu de ce registre vers l'extérieur du circuit 1. Le décalage d'états dans les bascules du registre 6 est piloté par un signal d'horloge de test LCCK. Comme on le verra par la suite, ce signal d'horloge de test LCCK sera soit un signal d'horloge interne de fréquence égale à la fréquence de fonctionnement du circuit 2, soit de fréquence égale à celle du signal TCK. La fréquence rapide sera utilisée pour charger en série, dans les bascules B'1 à B'M, les motifs résultants apparaissants sur la sortie OUT. La fréquence moins rapide, autrement dit la fréquence du signal d'horloge externe TCK, sera utilisée pour fournir les motifs résultants vers l'extérieur du circuit intégré 1.

Pour mémoriser un motif de test de N états logiques (ces N états logiques étant N vecteurs de test de dimension 1 ou N états de N vecteurs de test de dimension supérieure) dans le registre 4, on fournit en série ce motif sur l'entrée 12, le signal d'horloge externe TCK étant actif. Par décalage dans les bascules B1, B2, ... BN, on dispose dans ces bascules, après une durée correspondant à N périodes du signal TCK, des N états logiques du motif de test.

Pour transférer, vers l'extérieur, un motif résultant de M états logiques depuis le registre 6, on opère par décalage dans les bascules B'1, B'2, ... B'M, le signal d'horloge externe TCK étant actif et fourni aux bascules du registre 6 (on a lors LCCK = TCK). Après une durée correspondant à M périodes du signal TCK, ces M états logiques ont été fournis à la sortie 16.

Pour mettre en oeuvre le procédé de test selon l'invention, le circuit 1 comprend un circuit 18 générateur de signal d'horloge et un circuit de contrôle 20. On supposera que les circuits 18 et 20 sont programmables et accessibles depuis l'extérieur, par le biais d'un port d'entrée 22 du circuit 1.

Le circuit 18 fournit un signal d'horloge interne CKFAST. On suppose que ce signal interne CKFAST a une fréquence pouvant être supérieure à la fréquence de fonctionnement maximale admissible des entrées/sorties primaires du circuit 1. Pour rendre observable ce signal à l'extérieur du circuit 1, le circuit 1 comprend un diviseur de fréquence 24 comprenant une entrée recevant le signal CKFAST et une sortie reliée à une sortie primaire 26 du circuit 1 et permettant de fournir un signal d'horloge dérivé OCK, de fréquence représentative de la fréquence du signal CKFAST. On ne décrira pas en détail la constitution du circuit 24, ce type de circuit étant bien connu dans le domaine des circuits intégrés. Bien entendu, on choisira le facteur de division de la fréquence du signal CKFAST de telle sorte que la fréquence du signal dérivé OCK soit compatible avec la fréquence maximale admissible par les entrées/sorties primaires du circuit 1 et par la machine de test utilisée pour tester le circuit 2.

Le signal d'horloge interne CKFAST est fourni au circuit de contrôle 20 qui permet de piloter la mise en oeuvre des tests du circuit 2. En pratique, ce circuit de contrôle va contrôler le multiplexeur 8, le circuit interne 2 et le remplissage du registre 6, en leur fournissant des signaux d'horloge et de contrôle. Ainsi, on a représenté un signal de sélection PHASE, fourni au multiplexeur 8, et le signal d'horloge de test LCCK, fourni aux entrées C des bascules du registre de test 6 et au circuit logique 2.

Typiquement, le signal PHASE est un signal de sélection permettant de relier, respectivement, les entrées du multiplexeur 8 à sa sortie. Bien entendu, si N est supérieur à 2, le signal de sélection PHASE sera en fait formé d'un ensemble de plusieurs signaux de sélection. Ainsi, dans l'exemple illustré qui suit, on supposera que le registre 4 comprend quatre bascules et que le multiplexeur reçoit deux signaux de sélection PHASE0 et PHASE1.

Le signal d'horloge de test LCCK est utilisé, lors des tests, pour synchroniser le fonctionnement du circuit logique interne 2. Ce signal pourra aussi être fourni au circuit 2 lors du fonctionnement normal du circuit 1. Il pourra aussi être dédié au test fonctionnel du circuit 2 et être remplacé, en fonctionnement normal, par un autre signal d'horloge (fourni au circuit 2, par exemple, par un multiplexeur recevant les deux signaux d'horloge et commandé par le signal MODE).

On va maintenant donner un exemple de réalisation détaillé des éléments constituant les ressources de test, et plus particulièrement des circuits 18 et 20.

On supposera que l'on a N = M = 4. En pratique, on pourra avoir M > N si la fourniture de N états sur l'entrée IN induit la production d'un nombre supérieur d'états sur la sortie OUT.

Dans un premier mode de test, dit en rafale, on va produire un ou plusieurs trains de N+1 impulsions dans le signal d'horloge de test LCCK. Lors des N premières impulsions, les états présents en sortie des bascules Bl à BN sont fournis au circuit 2. Une impulsion supplémentaire est prévue pour tenir compte de la répercussion, sur la sortie OUT, de la fourniture du N-ième état sur l'entrée IN. On pourra, suivant le type de circuit testé, utiliser un train de plus de N+1 impulsions, selon le délai induit, par le circuit testé, entre le moment où sa ou ses entrées reçoivent des états donnés et le moment où ces états induisent une modification des états sur la ou les sorties du circuit testé. Autrement dit, le fonctionnement du circuit logique interne est limité, temporellement, à la durée nécessaire pour qu'il reçoive un vecteur de test et qu'il produise, en conséquence, un vecteur résultant.

Dans un second mode de test, dit en continu, on va produire un signal d'horloge de test LCCK oscillant continûment, de sorte que l'on pourra, par exemple, procéder à des tests de consommation ou de vieillissement.

### 1 - Moyens de mise en oeuvre du test.

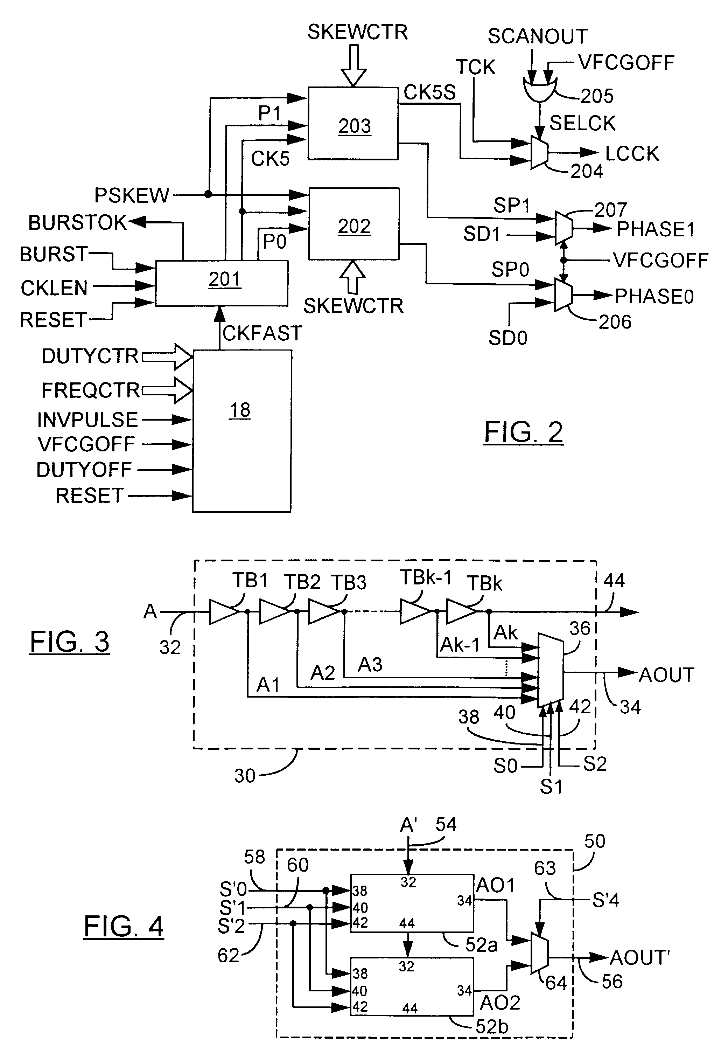

La figure 2 illustre un schéma bloc de l'ensemble formé par le circuit générateur de signal d'horloge 18 et le circuit de contrôle 20.

Comme on l'a mentionné, le circuit 18 produit un signal d'horloge interne CKFAST, que l'on va utiliser pour produire le signal d'horloge de test LCCK fourni au circuit logique 2 et au registre de test 6.

Le circuit 18 reçoit des signaux de commande du port 22 (non représenté).

Dans l'exemple illustré, le circuit 18 reçoit :
- un premier signal de commande RESET qui commande la réinitialisation des circuits de test,
- un deuxième signal logique de commande VFCGOFF qui permet de commander le démarrage ou l'arrêt de la production du signal d'horloge interne CKFAST,
- un troisième signal logique de commande INVPULSE qui détermine la polarité du signal d'horloge interne CKFAST,
- un quatrième signal de commande DUTYOFF qui commande un mode de programmation du rapport cyclique du signal d'horloge interne CKFAST,
- un premier ensemble de signaux de commande FREQCTR qui contrôlent la fréquence du signal d'horloge interne CKFAST,
- un deuxième ensemble de signaux de commande DUTYCTR qui contrôlent le rapport cyclique du signal d'horloge interne CKFAST lorsque le signal DUTYOFF est dans un état donné, par exemple lorsque DUTYOFF = 0.

Le circuit de contrôle 20 comprend un ensemble de circuits 201, 202, 203, 204, 205, 206 et 207.

Il reçoit des signaux de commande depuis l'extérieur, par le biais du port 22 (non représenté) et fournit des signaux de pilotage des moyens de test et un signal représentatif de la durée de trains d'impulsions dans le mode de test en rafale.

Le signal d'horloge interne CKFAST est fourni à un circuit de production de signaux de pilotage 201 qui produit, à partir de ce signal, un signal d'horloge filtré CK5 et des signaux de sélection primaires P0 et P1.

En mode de test en rafale, le signal d'horloge filtré CK5 est réalisé à partir d'un fenêtrage temporel du signal d'horloge interne CKFAST. Il reproduit les changements d'état du signal CKFAST pendant une période temporelle limitée. Sinon il est dans un état constant. En pratique, on va produire un fenêtrage tel qu'un train d'impulsions dans le signal filtré CK5 comprenne un nombre déterminé de N + 1 = 5 impulsions. Ce signal CK5 sera utilisé pour produire le signal d'horloge de test LCCK appliqué au circuit 2 et au registre 6, lors du test.

Les signaux de sélection primaires P0 et P1, synchrones avec le signal d'horloge filtré CK5, sont utilisés, comme on le verra ci-après, pour commander le multiplexeur 8, c'est-à-dire pour piloter, en mode de test, la fourniture d'états logiques à l'entrée IN du circuit logique interne 2.

Le circuit 201 reçoit des signaux de commande du port 22.

Dans l'exemple, le circuit 201 reçoit ainsi :
- le signal de réinitialisation RESET,
- un signal de commande CKLEN permettant de commander la production des impulsions dans le signal CK5, ces impulsions étant limitées temporellement, en mode de test en rafale, et
- un signal de commande BURST permettant de commander le mode de test, en rafale (on supposera alors que BURST = 1) ou en continu (on supposera alors que BURST = 0).

Enfin, le circuit 201 fournit un signal logique BURSTOK représentatif de la durée de trains d'impulsions dans le mode de test en rafale. On produira le signal BURSTOK, dans l'exemple, de sorte qu'il soit dans un état logique haut lorsque le signal CK5 est formé d'impulsions et qu'il soit dans un état logique bas sinon. Ainsi, en mode de test en rafale, le signal logique BURSTOK présente un changement d'état pendant une période correspondant à N+1 impulsions dans le signal CK5. Il est donc de fréquence inférieure au signal d'horloge interne, ce qui permet de le fournir sur une sortie du circuit 1. Bien entendu, on suppose ici que la fréquence du signal BURSTOK est compatible avec les fréquences de fonctionnement maximales des entrées/sorties du circuit 1 et de l'appareil de test. Si une période de N + 1 impulsions est trop faible, on pourra produire, le cas échéant, un changement d'état plus long du signal BURSTOK. Par échantillonnage du signal BURSTOK, on pourra déterminer le nombre d'impulsions dans le signal CK5, sachant que le signal d'horloge dérivé OCK permet par ailleurs de détenniner la fréquence de ce signal.

Les signaux CK5 et P0 sont fournis à un circuit de déphasage 202 qui reçoit par ailleurs un signal logique de commande PSKEW et un ensemble de signaux de commande SKEWCTR. Les signaux SKEWCTR permettent de programmer la valeur d'un déphasage entre les signaux P0 et CK5. Le signal PSKEW commande le sens, avance ou retard, de ce déphasage. Le circuit de déphasage 202 produit un signal de sélection SP0 reproduisant le signal P0, assorti d'un déphasage qui est fonction des états des signaux SKEWCTR et PSKEW.

Les signaux CK5 et P1 sont fournis à un circuit de déphasage 203 qui reçoit par ailleurs le signal logique PSKEW et l'ensemble de signaux SKEWCTR. Les signaux SKEWCTR permettent de programmer la valeur d'un déphasage des signaux P1 et CK5. Le signal PSKEW commande le sens, avance ou retard, de ce déphasage. Le circuit de déphasage 203 produit un signal de sélection SP1 reproduisant le signal P1, assorti d'un déphasage qui est fonction des états des signaux SKEWCTR et PSKEW. Il produit également un signal d'horloge CK5S reproduisant le signal CK5, assorti d'un déphasage qui est fonction des signaux SKEWCTR et PSKEW.

Le signal d'horloge de test LCCK est produit en sélectionnant le signal d'horloge interne CK5S ou le signal d'horloge externe TCK. Cette sélection est réalisée, dans l'exemple, par le biais d'un multiplexeur 204 à deux entrées recevant lesdits signaux sur ses entrées. On prévoit que LCCK = TCK quand la production du signal d'horloge interne CKFAST est arrêtée ou quand on souhaite procéder au décalage d'états logiques du circuit 1 vers l'extérieur.

Ainsi, dans l'exemple, le multiplexeur 204 est commandé par un signal logique de commande de sélection SELCK. Le signal SELCK est produit par une porte logique 205 à deux entrées de type OU. Cette porte 205 reçoit le signal VFCGOFF sur une première entrée et un signal logique de commande SCANOUT sur l'autre entrée. Le signal SCANOUT, reçu par exemple sur le port 22, permet de commander la sélection du signal d'horloge externe TCK pour piloter les bascules du registre 6 lors du décalage du contenu de ce registre vers l'extérieur.

Dans l'exemple illustré, on produit deux signaux logiques de sélection PHASE0 et PHASE1 pour commander le multiplexeur 8. Ces deux signaux permettent de former quatre états logiques, ce qui correspond au nombre N d'entrées du multiplexeur 8. Ces signaux PHASE0 et PHASE1 sont produits par des circuits de sélection 206 et 207 qui permettent soit d'avoir PHASE0 = SP0 et PHASE1 = SP1, soit d'avoir PHASE0 = SD0 et PHASE1 = SD1, avec SD0 et SD1 des signaux fournis au circuit 1 depuis l'extérieur. Dans l'exemple illustré, ces circuits de sélection 206 et 207 sont deux multiplexeurs commandés par le signal logique VFCGOFF. Il est ainsi possible de commander directement le multiplexeur 8 depuis l'extérieur, ce qui peut être utile en cas de défaillance des circuits 18 et/ou 20 ou de blocage lors d'un test. Il reste alors possible de contrôler les registres 4 et 6 depuis l'extérieur et de faire fonctionner le circuit 2 (on utilise alors le signal d'horloge externe TCK).

On va maintenant décrire plus en détail des exemples de réalisation des éléments de la figure 2 et leur fonctionnement.

Pour produire le signal d'horloge interne CKFAST, on utilise, par exemple, un oscillateur en anneau. Cet oscillateur sera de préférence programmable, de sorte que l'on pourra produire un signal d'horloge interne de fréquence variable, ce qui permet de tester le circuit 2 à des fréquences variables. On pourra ainsi déterminer, par exemple, la fréquence de fonctionnement maximale admissible par le circuit 2 et déterminer quels types d'opérations limitent la valeur de cette fréquence.

### 2 - Oscillateur en anneau.

La figure 3 illustre un exemple de circuit de retard 30 permettant de réaliser un oscillateur en anneau programmable. Il comprend une entrée 32 pour recevoir un signal logique d'entrée A et une sortie 34 pour fournir un signal logique de sortie AOUT. Le signal A est fourni à un ensemble de k circuits tampons TB1, TB2, ... TBk montés en série.

Chaque circuit tampon a une entrée et une sortie. Son entrée est reliée à l'entrée 32, pour le circuit TB1, ou à la sortie du circuit qui le précède. Ces circuits tampons seront, par exemple, formés de deux inverseurs montés en série. De la sorte, chaque circuit tampon reproduit sur sa sortie le signal qu'il reçoit sur son entrée, affecté d'un retard dépendant du dimensionnement de ses inverseurs. Les signaux, notés A1, A2, ... Ak, présents sur les sorties des circuits TB1, TB2, ... TBk, sont fournis à k entrées d'un multiplexeur 36 à k entrées. Ce multiplexeur 36 a une sortie qui fournit le signal AOUT, la sélection de l'entrée fournissant le signal AOUT s'opérant en fonction des états de signaux logiques de sélection fournis au multiplexeur 36. Dans l'exemple, on a considéré que le circuit 30 recevait trois signaux de sélection S0, S1 et S2 sur des entrées 38, 40 et 42. On pourra ainsi commander un multiplexeur ayant huit entrées ou moins.

Pour former un oscillateur en anneau, il suffit de relier l'entrée 32 et la sortie 34 par le biais d'un nombre impair de portes inverseuses, de telle sorte que le nombre de circuits inverseurs montés en série soit impair. On produira alors un signal oscillant de fréquence inversement proportionnelle au nombre d'inverseurs formant l'oscillateur en anneau. On pourra bien entendu ne pas fournir tous les signaux produits par les circuits tampons au multiplexeur de sortie. Cela permet de limiter l'encombrement du circuit et des moyens de fourniture des signaux de sélection, au détriment du nombre de fréquences différentes que l'on peut fournir en sortie.

Le circuit 30 comprend une sortie 44 pour fournir le signal Ak. Cela permet de réaliser plusieurs oscillateurs en anneau de longueurs différentes pour fournir sélectivement des signaux d'horloge de fréquences différentes. La figure 4 représente ainsi un circuit de retard 50 formé de deux circuits de retard 52a et 52b que l'on supposera identiques au circuit de retard 30.

Le circuit de retard 50 comprend une entrée 54 permettant de recevoir un signal logique A'. Cette entrée 54 est reliée à l'entrée 32 du circuit 52a. L'entrée 32 du circuit 52b est reliée à la sortie 44 du circuit 52a. Les circuits 52a et 52b fournissent respectivement, sur leur sortie 34, des signaux logiques AO1 et AO2. Leurs entrées de commande 38, 40 et 42 sont reliées à des entrées de commande 58, 60 et 62 de sorte qu'ils reçoivent des signaux logiques de commande S'0, S'1 et S'2. Enfin, le circuit 50 comprend une sortie 56 pour fournir un signal de sortie AOUT' et une entrée 63 pour recevoir un signal logique de sélection S'4. Le signal de sortie AOUT' est fourni par un multiplexeur 64 qui reçoit les signaux AO1 et AO2 sur deux entrées et le signal S'4 sur une entrée de commande de sorte que l'on a AOUT' = AO1 ou AOUT' = AO2.

De même que précédemment, pour produire un signal oscillant, il suffit de relier l'entrée 54 et la sortie 56, par le biais d'un nombre impair de portes inverseuses. Le circuit 52a fournira un premier signal oscillant AO1 et le circuit 52b fournira un second signal oscillant AO2, de fréquence plus faible.

On pourra bien entendu utiliser un nombre plus important de circuits en parallèle. On pourra, si on le souhaite, fournir des signaux de commande différents aux circuits montés en série, ce qui permet d'obtenir plus de souplesse, au détriment de la surface occupée par le circuit de retard 50.

### 3 - Circuit générateur d'horloge.

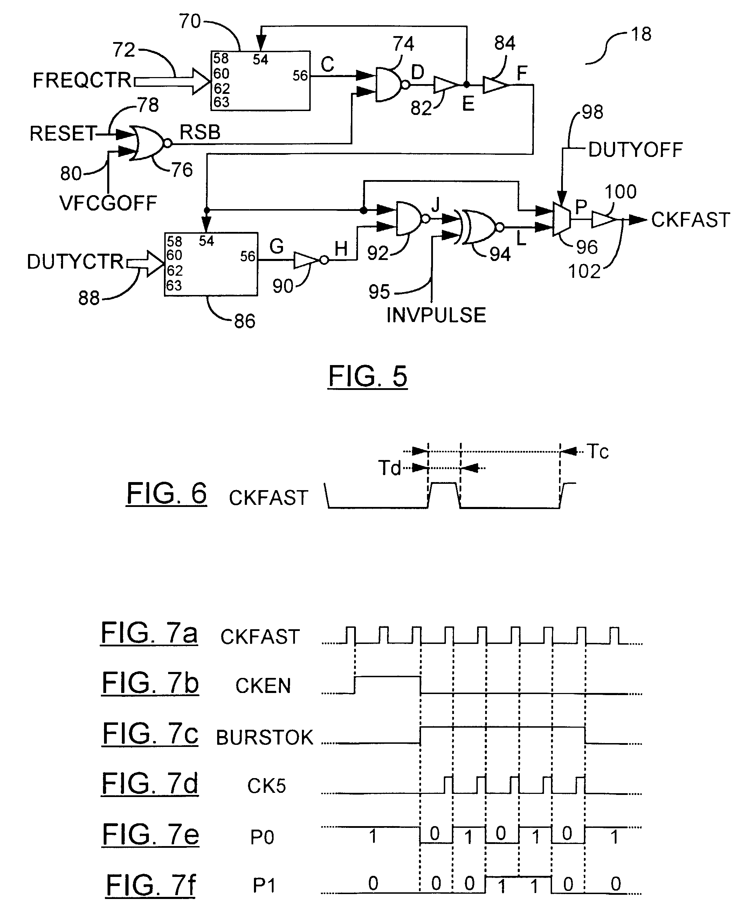

La figure 5 illustre un exemple de réalisation du circuit 18 générateur d'horloge.

Comme on l'a mentionné, il fournit le signal d'horloge interne CKFAST par le biais d'oscillateurs en anneau pilotés en fonction de signaux de commande. Le signal CKFAST, illustré sur la figure 6, est un signal logique binaire que l'on définira par sa période Tc et par la durée Td pendant laquelle il est à l'état haut (autrement dit, par son temps de cycle).

Le circuit 18 comprend un circuit de retard programmable 70 que l'on supposera réalisé conformément au circuit 50 illustré sur la figure 4.

Il est piloté par l'ensemble de signaux de contrôle FREQCTR, reçu sur une entrée 72 du circuit 18. On note C le signal logique produit sur la sortie 56 du circuit 70. Ce signal logique C est un signal carré. Il est fourni à une première entrée d'une porte logique 74 à deux entrées, de type NON_ET. Cette porte 74 reçoit un signal logique de validation RSB sur sa deuxième entrée. Le signal RSB est fourni par une porte logique 76 de type NON_OU, à deux entrées. Les entrées de la porte 76 reçoivent les signaux logiques de commande RESET et VFCGOFF, ces signaux étant reçus sur des entrées 78 et 80 du circuit 18.

La porte logique 74 produit un signal logique D qui est fourni à l'entrée d'un circuit tampon 82. Le circuit tampon 82 produit un signal logique E qui est fourni à l'entrée 54 du circuit 70.

Lorsque le signal de validation RSB est à l'état bas, le signal D est constamment à l'état haut. Le signal C est alors constamment à l'état haut. Pour positionner le signal RSB à l'état bas, il suffit de positionner l'un des signaux RESET ou VFCGOFF à l'état haut. Lors d'un test, typiquement, on procédera à l'initialisation des moyens de test en mettant le signal RESET à l'état haut, le signal VFCGOFF étant à l'état haut. Une fois l'initialisation réalisée, on pourra à volonté produire ou ne pas produire de signal d'horloge interne, en contrôlant l'état du signal VFCGOFF. Si ce dernier est à l'état bas, le signal RSB sera positionné à l'état haut. La porte 74 sera alors équivalente à un inverseur recevant le signal C en entrée. Si on considère que le circuit tampon 82 est formé de deux inverseurs montés en série, on a alors une connexion de l'entrée 54 et de la sortie 56 du circuit 70 par le biais d'un nombre impair de portes inverseuses. Le signal C va donc osciller, à une fréquence qui dépendra des états des signaux de commande formant l'ensemble FREQCTR. Par ailleurs, le signal C, si on suppose que l'on dispose d'inverseurs ayant des délais de transitions positive et négative équivalentes, sera un signal carré.

L'utilisation conjuguée des signaux RESET et VFCGOFF permet de s'affranchir de risques de double propagation de signaux dans l'oscillateur en anneau fournissant le signal CKFAST. Un tel risque se présente si l'on modifie la fréquence du signal d'horloge interne alors qu'il est en production. L'utilisation du signal VFCGOFF permet de stopper temporairement la production du signal CKFAST lors de modifications des signaux de commande, sans qu'il soit pour autant nécessaire de réinitialiser l'ensemble des circuits dédiés au test.

Le circuit 18, outre qu'il permet de produire un signal d'horloge de fréquence programmable, comprend des moyens de programmation de son temps de cycle et de sa polarité.

Pour ce faire, on fournit le signal logique E à un circuit à retard programmable 86 que l'on supposera semblable au circuit 50 de la figure 4. Dans l'exemple, le signal E est fourni par le biais d'un circuit tampon 84 qui reçoit le signal E en entrée et produit un signal logique F. Ce signal F est fourni à l'entrée 54 du circuit 86. On note G le signal logique produit sur la sortie 56 du circuit 86. Le signal G est un signal carré, retardé par rapport au signal F. Le circuit 86 va, en effet, modifier le signal F en fonction de l'ensemble de signaux de commande DUTYCTR, reçu sur une entrée 88 du circuit 18.

Le circuit 18 comprend, en outre, un inverseur 90, une porte logique 92 de type NON_ET, à deux entrées, une porte logique 94 de type NON_OU_EXCLUSIF, à deux entrées, un multiplexeur 96 et un circuit tampon 100.

Le signal G est fourni à l'inverseur 90 qui produit un signal logique H inverse du signal G. Les signaux logiques F et H sont fournis aux entrées de la porte 92. La porte 92 produit un signal logique intermédiaire J. Ce signal J est fourni à une entrée de la porte 94. La porte reçoit en outre, d'une entrée 95 du circuit 18, le signal logique de commande INVPULSE. On note L le signal logique produit par la porte 94. Les signaux F et L sont fournis aux entrées du multiplexeur 96. Ce multiplexeur reçoit, d'une entrée 98 du circuit 18, le signal logique de commande DUTYOFF. Il produit un signal logique noté P. En fonction de l'état du signal DUTYOFF, on aura P = F (par exemple si DUTYOFF = 1) ou P = L (si DUTYOFF = 0). Le signal P est fourni au circuit tampon 100, ce circuit tampon produisant le signal d'horloge interne CKFAST.

Si l'on a DUTYOFF = 1, le signal CKFAST est un signal d'horloge carré, reproduisant le signal F.

Supposons que l'on souhaite modifier le rapport cyclique du signal CKFAST de sorte qu'il ne soit plus de 50 %. Pour ce faire, on positionne le signal DUTYOFF à l'état bas. On utilise alors le signal L pour produire le signal d'horloge interne CKFAST.

Le circuit 86 va retarder de manière plus ou moins importante le signal F, selon l'état de l'ensemble de signaux DUTYCTR. Considérons les fronts montants du signal F. Les fronts montants du signal G seront retardés par rapport aux fronts montants du signal F. Le signal G étant inversé pour produire le signal H, on va obtenir un signal H dont les fronts montants seront en quelque sorte retardés par rapport à ceux du signal F. La porte 92 va produire un signal J dont les fronts descendants correspondent aux fronts descendants dans le signal F et dont les fronts montants correspondent aux fronts montants dans le signal H.

Supposons que l'on ait INVPULSE = 0. La porte 94 se comporte alors comme un inverseur recevant le signal J en entrée. Autrement dit, les fronts montants du signal L (et, par suite, du signal CKFAST) correspondent aux fronts montants du signal F. La position des fronts descendants du signal L va dépendre du retard induit par le circuit 86. En tout état de cause, l'inversion dans l'inverseur 90 équivalant en quelque sorte à avancer le signal G par rapport au signal F, les fronts descendants du signal L (et, par suite, du signal CKFAST) seront temporellement en avance sur les fronts descendants du signal F. On produit donc un signal CKFAST de rapport cyclique inférieur à 50 %, dont les fronts montants correspondent aux fronts montants du signal F.

En positionnant le signal INVPULSE à l'état haut, on produira, de manière simple, un signal CKFAST de rapport cyclique supérieur à 50 %. Le signal L est alors équivalent au signal J, c'est-à-dire de rapport cyclique supérieur à 50 % et dont les fronts montants sont retardés par rapport aux fronts montants du signal F.

### 4 - Circuit de synchronisation.

Pour ce qui concerne l'exemple de réalisation du circuit de production de signaux de pilotage 201, on en donnera une description fonctionnelle, en langage VHDL :

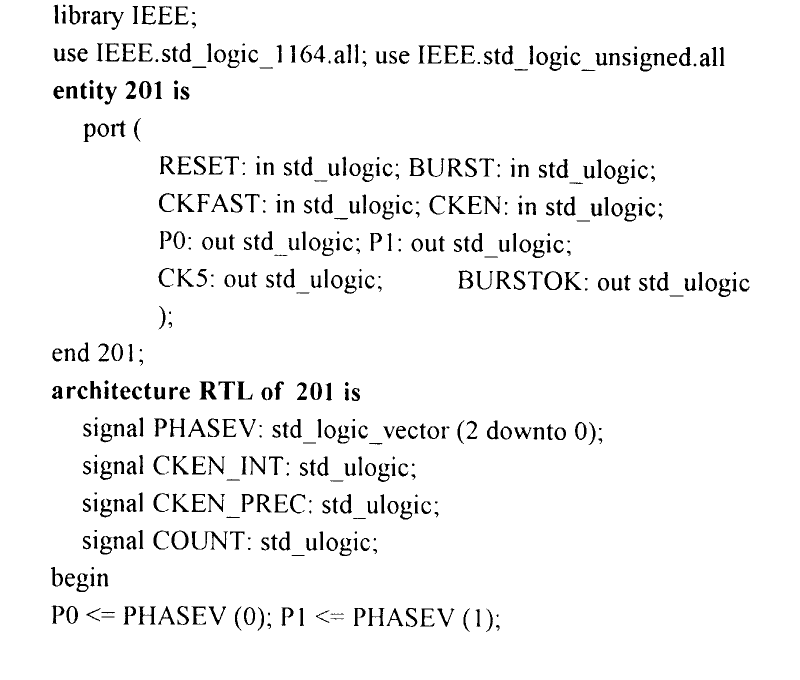

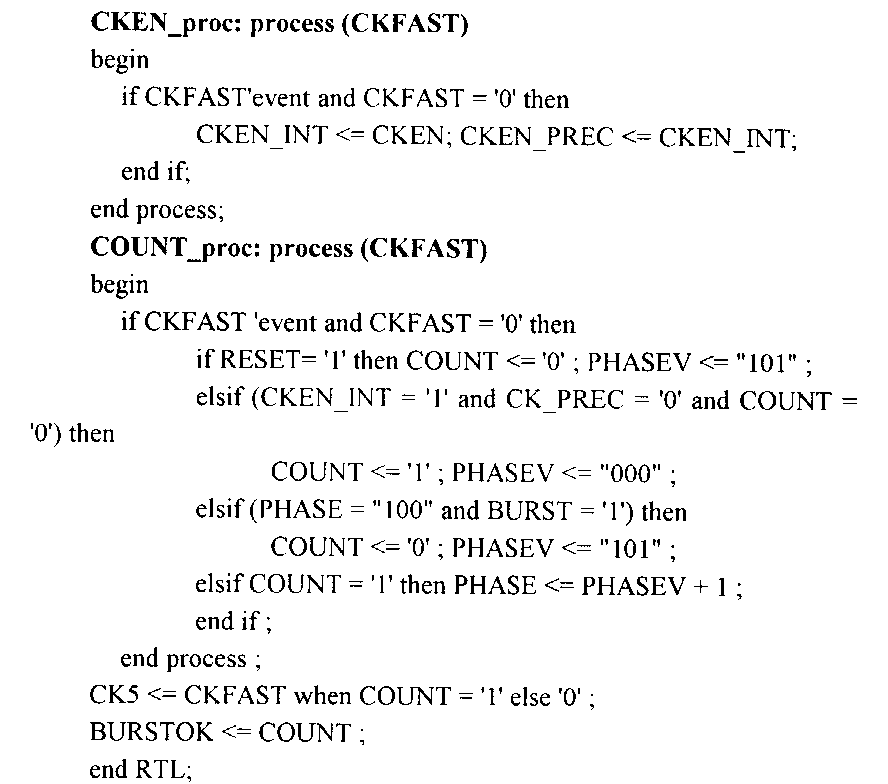

Entre les lignes "entity 201" et "end 201", on définit les signaux logiques reçus (RESET, BURST, CKFAST, CKEN) par le circuit 201 et les signaux produits (P0, P1, CK5, BURSTOK) par le circuit 201. Ces signaux sont des signaux logiques de type classique, pouvant prendre deux états logiques notés 0 (état bas) et 1 (état haut).

Entre les lignes "architecture RTL ..." et "end RTL", on décrit le fonctionnement souhaité pour le circuit 201. On définit, en premier lieu, des signaux logiques internes au circuit 201 qui sont utilisés pour produire les signaux fournis en sortie par ce circuit. On va utiliser un vecteur logique de dimension 3, noté PHASEV (on notera PHASEV(2), PHASEV(1) et PHASEV(0) ses composantes), des signaux CKEN_INT et CKEN_PREC représentatifs d'états du signal de commande CKEN, et un signal COUNT représentatif de la mise en oeuvre ou de l'absence d'un comptage. Les signaux PHASEV(1) et PHASEV(0) correspondent aux signaux de sortie P0 et P1, le signal PHASEV(2) restant interne au circuit 201.

Une première routine, notée CKEN_proc, définit les états affectés aux signaux CKEN_INT et CKEN_PREC. Quand un front descendant apparaît dans le signal d'horloge CKFAST, on affecte l'état courant du signal CKEN au signal CKEN_INT et on affecte l'ancien état du signal CKEN_INT au signal CKEN_PREC. Dans le circuit 201, c'est le signal CKEN_INT qui va commander la production des signaux de sortie. L'état du signal CKEN n'étant pris en compte que sur front descendant du signal CKFAST, on garantit un synchronisme des circuits 18 et 201, les signaux fournis au circuit 1, tel que le signal CKEN, et le signal d'horloge interne CKFAST étant, par ailleurs, a priori asynchrones.

Une seconde routine, notée COUNT_proc, définit les états des signaux fournis en sortie par le circuit 201. Les changements d'état de ces signaux vont être réalisés, comme précédemment, sur front descendant du signal CKFAST.

Pour initialiser le circuit 201, on positionne le signal RESET à l'état haut. On va alors positionner le signal COUNT à l'état bas et on a PHASEV = 010 (autrement dit, les signaux PHASEV(2), PHASEV(1) et PHASEV(0) sont positionnés, respectivement, à l'état haut, à l'état bas et à l'état haut). Le signal CK5 est positionné à l'état bas. Pour démarrer un test, il suffit que le signal CKEN passe de l'état bas à l'état haut. Alors on positionne le signal COUNT à l'état haut. Le signal CK5 va alors reproduire le signal CKFAST. Parallèlement, le signal BURSTOK passe à l'état haut.

En ce qui concerne le vecteur PHASEV, on va lui imposer une valeur initiale 000. On a alors P0 = 0 et P1 = 0. Puis, on l'incrémente à chaque front descendant dans le signal CKFAST. Il va donc prendre, successivement, les valeurs 000, 001, 010, 011, 100, 101, 110, 111, 000, 001 etc. Les états des signaux P0 et P1 seront successivement 0 et 0, 0 et 1, 1 et 0, 1 et 1, 0 et 0 etc.

Ce fonctionnement correspond au test en mode continu.

Si on souhaite mettre en oeuvre un test par rafale, alors on positionne le signal BURST à l'état haut. Dans ce cas, lorsque le vecteur PHASEV a atteint la valeur 100, on lui impose la valeur 101 et on positionne le signal COUNT à l'état bas, ce qui correspond à une initialisation du circuit 201.

Les figures 7a à 7f illustrent le fonctionnement du circuit 201.

On suppose que le signal VFCGOFF est à l'état bas et que le circuit 18 produit un signal d'horloge interne CKFAST (illustré sur la figure 7a), de fréquence donnée. Les signaux RESET, CKEN, BURSTOK, CK5 et P1 sont initialement à l'état bas et les signaux BURST et P0 sont initialement à l'état haut. Les signaux P1 et P0 forment donc la combinaison logique 10.

Supposons que le signal CKEN (illustré sur la figure 7b) soit positionné à l'état haut et soit remis ultérieurement à l'état bas. Le passage du signal CKEN de l'état haut à l'état bas entraîne la montée à l'état haut du signal BURSTOK. Parallèlement, le signal CK5 (illustré sur la figure 7d) commence à reproduire les impulsions du signal CKFAST et le couple (P0, P1) commence à prendre une série prédéterminée d'états. Lors des N + 1 impulsions du signal d'horloge filtré CK5, les signaux de sélection primaires P1 et P0, illustrés sur les figures 7e et 7f, vont ainsi prendre successivement les états suivants : 00, 01, 10, 11 et 00. On va donc relier successivement, lors des N premières périodes, les N entrées du multiplexeur 8 à sa sortie. Une fois la (N + 1) - ième période écoulée, le signal BURSTOK redescend à l'état bas. Les signaux reprennent alors leurs états initiaux.

Si on choisit BURST = 0, alors le signal CK5 reproduira les impulsions du signal CKFAST, aussi longtemps que le signal BURST ne changera pas d'état. On peut alors, en fournissant sans interruption des vecteurs de test, opérer des tests de consommation et/ou de fiabilité. Pour tester la consommation moyenne du circuit 1, le circuit 2 fonctionnant en permanence, il suffit de mesurer celle-ci sur les bornes d'alimentation (non représentées) du circuit 1. On pourra tester la consommation du circuit 1 en fonction de l'opération réalisée par le circuit 2, si celui-ci peut réaliser plusieurs types d'opération. Il suffit pour cela, une fois la consommation mesurée pour un type d'opération, de modifier les vecteurs de test fournis et de reprendre une nouvelle mesure. Pour tester la fiabilité du circuit 2, on pourra par exemple lui faire opérer en boucle une même opération. Régulièrement, on transférera le ou les vecteurs résultants en dehors du circuit 1, et on les comparera aux vecteurs attendus ou précédemment transférés. Cela peut être utile pour les circuits sujets à un vieillissement pouvant altérer leur fonctionnement, tels que les mémoires, par exemple.

Le signal BURSTOK est à l'état haut aussi longtemps que le signal CK5 reproduit le signal CKFAST. Il peut être utilisé, à l'extérieur du circuit 1, pour vérifier si les trains d'impulsions, en mode de test en rafale, comportent bien le nombre d'impulsions désiré. Il suffit, pour cela, de mesurer la durée du changement d'état du signal BURSTOK, sachant que l'on peut déterminer par ailleurs la fréquence du signal CKFAST en mesurant la fréquence du signal OCK.

### 5 - Circuit de déphasage.

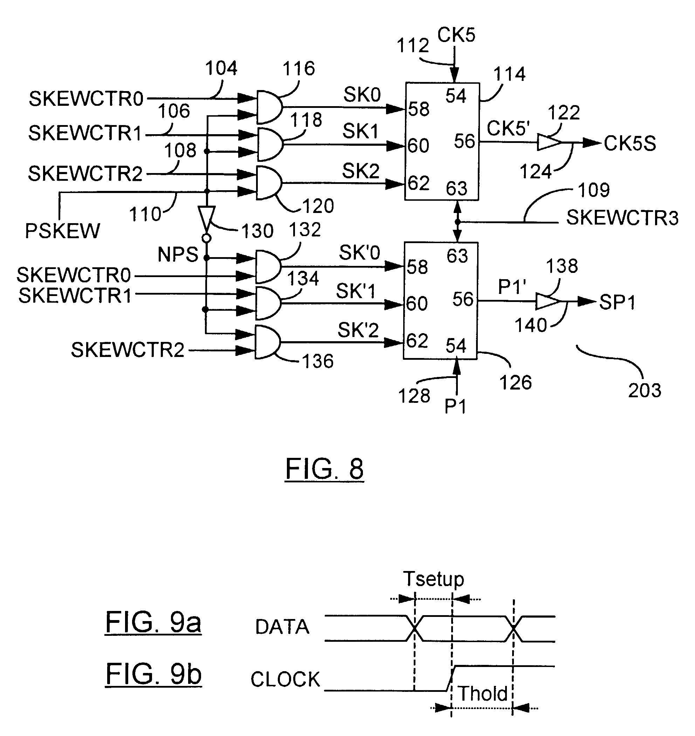

La figure 8 illustre un exemple de réalisation du circuit de déphasage 203 illustré sur la figure 2. Il permet d'introduire un déphasage entre les signaux CK5, P0, P1 produits par le circuit de production de signaux de pilotage 201, avant qu'ils soient fournis au multiplexeur 8 (en ce qui concerne P0 et P1), et au circuit 2 et au registre 6 (en ce qui concerne CK5).

On supposera, ici, que la fourniture de signaux à l'état bas sur les entrées 58, 60 et 62 d'un circuit à retard programmable identique au circuit à retard programmable 50 permet de sélectionner, en sortie, le signal le plus retardé. Autrement dit, en référence à la figure 4, le signal produit sur la sortie 56 correspondra alors au signal Ak du circuit de retard 52b. Si l'un des signaux fournis sur les entrées 58, 60 et 62 est à l'état haut, alors le retard introduit entre l'entrée 54 et la sortie 56 par le circuit 50 sera plus faible.

Le circuit 203 reçoit, du circuit 201, les signaux CK5 et P1 sur des entrées 112 et 128. Il reçoit par ailleurs l'ensemble SKEWCTR de signaux de commande, formé de quatre signaux logiques SKEWCTR0, SKEWCTR1, SKEWCTR2 et SKEWCTR3, reçus sur des entrées 104, 106, 108 et 109. Il reçoit, enfin, le signal logique de commande PSKEW sur une entrée 110. Le circuit 203 fournit les signaux logiques CK5S et SP1 sur des sorties 124 et 140.

Le circuit 203 comprend deux circuits à retard programmables 114 et 126 que l'on supposera identiques au circuit 50 illustré sur la figure 4.

Le circuit 114 reçoit le signal CK5 sur son entrée 54. Il fournit, sur sa sortie 56, un signal logique CK5'. Ce signal est fourni à un circuit tampon 122 qui produit le signal CK5S à partir de CK5'.

Le circuit 114 reçoit trois signaux logiques de contrôle SK0, SK1 et SK2 sur ses entrées 58, 60 et 62, et le signal SKEWCTR3 sur son entrée 63. Les signaux SK0, SK1 et SK2 sont produits par trois portes logiques 116, 118 et 120, de type ET à deux entrées. Les portes 116, 118 et 120 reçoivent chacune le signal PSKEW sur une entrée et, respectivement, les signaux SKEWCTR0, SKEWCTR1 et SKEWCTR2 sur leur deuxième entrée.

Le circuit 203 comprend un inverseur 130 qui reçoit le signal PSKEW en entrée, et produit un signal logique NPS, inverse du signal PSKEW.

Le circuit 126 reçoit le signal P1 sur son entrée 54. Il fournit, sur sa sortie 56, un signal logique P1'. Ce signal est fourni à un circuit tampon 138 qui produit le signal SP1 à partir de P1'.

Le circuit 126 reçoit trois signaux logiques de contrôle SK'0, SK'1 et SK'2 sur ses entrées 58, 60 et 62, et le signal SKEWCTR3 sur son entrée 63. Les signaux SK'0, SK'1 et SK'2 sont produits par trois portes logiques 132, 134 et 136, de type ET à deux entrées. Les portes 132, 134 et 136 reçoivent chacune le signal NPS sur une entrée et, respectivement, les signaux SKEWCTR0, SKEWCTR1 et SKEWCTR2 sur leur deuxième entrée.

Supposons que l'on ait PSKEW = 1 et SKEWCTR0 = SKEWCTR1 = SKEWCTR2 = 0, les signaux SK0, SK1, SK2, SK'0, SK'1 et SK'2 sont à l'état bas. En conséquence, les signaux CK5' et Pl' subiront un retard identique et aucun déphasage ne sera introduit entre les signaux CK5 et P1. En modifiant les signaux SKEWCTR0, SKEWCTR1 ou SKEWCTR2, on va diminuer le retard appliqué au signal CK5. Cela revient, corrélativement, à retarder le signal P1 par rapport au signal CK5. En effet, le signal NPS étant maintenu à l'état bas, le retard appliqué au signal P1 ne varie pas.

Si on souhaite opérer de manière inverse, en retardant le signal CK5 par rapport au signal P1, alors il suffit de positionner PSKEW à l'état bas.

Bien entendu, pour maintenir une cohérence dans la commande du multiplexeur 8, on réalisera le circuit de déphasage 202 de manière similaire au circuit 203.

Lors d'un test, les signaux LCCK et PHASE, produits à partir des signaux CK5S, SP0 et SP1, pourront ainsi être déphasés.

L'introduction d'un déphasage, entre le signal d'horloge LCCK appliqué au circuit 2 et les signaux de sélection PHASE appliqués au multiplexeur 8, permet de tester les délais minimaux d'établissement (dit de setup) et de maintien (dit de hold) de l'entrée ou des entrées logiques du circuit logique à tester, par rapport au signal d'horloge pilotant le circuit logique.

En référence aux figures 9a et 9b, considérons un circuit logique piloté par un signal d'horloge CLOCK (illustré sur la figure 9b) et recevant un signal logique DATA (illustré sur la figure 9a). On supposera que la prise en compte des changements d'état du signal DATA s'opère sur front montant du signal CLOCK. Par délai minimal d'établissement, noté Tsetup, on entend le délai temporel minimal à respecter entre une modification de l'état du signal DATA et le front montant du signal CLOCK pour assurer que la modification de l'état du signal DATA soit prise en compte par le circuit logique. Généralement, ce délai est positif, c'est-à-dire qu'une modification d'état du signal DATA ne peut être pris en compte que sur un front montant postérieur du signal CLOCK. Cela étant, il se peut que ce délai soit négatif, si le signal DATA est retardé avant de produire une action. Par délai minimal de maintien, noté Thold, on entend le délai minimal à respecter avant de pouvoir modifier l'état du signal DATA, si on souhaite qu'une modification antérieure soit prise en compte. Ce délai est généralement quasi - nul.

Bien entendu, des modifications pourront être apportées par l'homme du métier sans sortir du cadre de l'invention.

Ainsi, on pourra implémenter des dispositifs différents pour produire les signaux décrits. On pourra aussi modifier les polarités des différents signaux produits et adapter les circuits décrits en conséquence. On pourra également, par exemple, limiter les possibilités offertes par le circuit de test en produisant un signal CKFAST de fréquence et/ou de rapport cyclique et/ou de polarité fixés, ou bien encore en n'introduisant pas de déphasage entre les signaux d'horloge et de sélection.

On pourra bien sûr disposer de plusieurs registres de test fonctionnant parallèlement en entrée et/ou en sortie des circuits à tester, selon les dimensions des vecteurs de test et des vecteurs résultants, qui sont elles-mêmes fonction du type de circuit testé. Dans ce cas, lesdits registres pourront être reliés en série, afin de permettre un chargement et/ou un déchargement de ces registres à partir d'une seule entrée/sortie primaire. Si la dimension des vecteurs de test est supérieure ou égale à 2, on pourra associer un multiplexeur à chacun des registres qui stockent les motifs formés par l'ensemble de l'un des états des vecteurs.

On pourra également disposer plusieurs registres de test pour tester plusieurs circuits internes différents. Ces registres pourront être reliés en série, afin de permettre un chargement des registres de test et/ou un déchargement de ces registres à partir d'une seule entrée/sortie primaire.

De même, les registres de test et/ou une partie des bascules les composant pourront être utilisés à d'autres fins, en fonctionnement normal, en prévoyant des moyens de multiplexage adéquats sur des entrées et/ou des sorties de ces registres ou de ces bascules. Cela permet d'utiliser ces registres ou bascules en dehors du mode de test, ce qui est intéressant en terme de surface utile occupée pour le fonctionnement normal.

Les entrées/sorties primaires qui sont utilisées dans le cadre des tests fonctionnels pourront être utilisées à d'autres fins en fonctionnement normal, en rajoutant des moyens de multiplexage et de démultiplexage appropriés. Cette double fonctionnalité est bien connue dans le domaine des circuits intégrés, et présente l'avantage de limiter le nombre d'entrées/sorties primaires des circuits dédiés au test.

De même, on pourra définir des sens de transfert différents selon que l'on est en mode de test ou en fonctionnement normal. Les entrées et sorties primaires du circuit 1, en mode de test, pourront avoir une fonctionnalité différente en mode de fonctionnement normal. Ainsi, par exemple, l'entrée 12 pourra très bien être utilisée comme entrée en mode de test et comme sortie en mode de fonctionnement normal, ou inversement.

On pourra également utiliser un multiplexeur pour relier l'entrée D de la bascule B'1 sélectivement à la sortie OUT du circuit 2 ou à la sortie Q de la bascule BN. De la sorte, on pourra créer un seul registre de N + M bascules accessible en entrée, sur l'entrée 12, et en sortie, sur la sortie 16. On pourra ainsi tester les registres de test 4 et 6, en fournissant N + M états logiques sur l'entrée 12 et en procédant à un décalage de 2 * (N + M) cycles dans ces registres, de sorte à transférer ces états sur la sortie 16. Si les bascules fonctionnent correctement, alors les états transférés sur la sortie 16 correspondent aux états fournis sur l'entrée 12. On pourra, éventuellement, tester ces registres de manière indépendante, en utilisant des moyens pour relier la sortie de la bascule BN et l'entrée D de la bascule B'1 à des entrées/sorties primaires différentes du circuit 1, ce qui permet de minimiser la durée de ce test.

## Revendications

1. Procédé de test fonctionnel d'un circuit intégré (1) comprenant au moins un circuit logique interne (2) à tester, ce circuit logique interne comprenant au moins une entrée (IN) et une sortie (OUT),
le procédé comprenant :
- la fourniture d'au moins un motif de test formé d'un ensemble d'états logiques sur une première entrée (12) du circuit intégré, par décalage en série, et stockage de ce motif de test dans un premier registre de test (4), ladite fourniture étant synchronisée par un signal d'horloge externe (TCK) reçu sur une deuxième entrée (14) du circuit intégré,
- la fourniture en série de ce motif de test à l'entrée (IN) du circuit logique interne, ladite fourniture étant synchronisée par un signal d'horloge de test (LCCK) produit à partir d'un signal d'horloge interne (CKFAST) produit dans le circuit intégré, ledit premier signal d'horloge interne ayant une fréquence supérieure à la fréquence du signal d'horloge externe,
- le stockage, dans un deuxième registre de test (6) relié à la sortie (OUT) du circuit logique interne, d'au moins un motif résultant produit par le circuit logique interne quand on lui fournit le motif de test, ledit stockage étant synchronisé par le signal d'horloge de test, et
- la fourniture, par décalage en série, sur une première sortie (16) du circuit intégré, du motif résultant, ladite fourniture étant synchronisée par le signal d'horloge externe (TCK).

2. Procédé selon la revendication 1, caractérisé en ce que le signal d'horloge interne (CKFAST) est produit par un oscillateur en anneau programmable.

3. Procédé selon l'une des revendications 1 ou 2, caractérisé en ce que la fourniture du motif de test au circuit logique interne (2) est réalisée par le biais d'un circuit de conversion parallèle/série (8), de sorte que l'on puisse fournir plusieurs fois ce motif de test au circuit logique interne, une fois ce motif stocké dans le premier registre de test (4).

4. Procédé selon l'une des revendications 1 à 3, caractérisé en ce que le signal d'horloge de test est produit par filtrage temporel du signal d'horloge interne (CKFAST), de sorte que le fonctionnement du circuit logique interne soit limité temporellement à la durée nécessaire pour qu'il reçoive le motif de test et qu'il produise le motif résultant.

5. Procédé selon les revendications 3 et 4, caractérisé en ce que le circuit de conversion parallèle/série est piloté par des signaux de commande (PHASE) dont la production est synchronisée avec la production du signal d'horloge de test, ces signaux de commande et d'horloge de test étant fournis au circuit de conversion parallèle/série et au circuit logique interne par le biais de circuits de déphasage (202, 203) programmables, de sorte que l'on puisse introduire un déphasage temporel entre les signaux de commande et le signal d'horloge de test.

6. Circuit intégré (1) comprenant un circuit logique interne (2) et des moyens de test pour tester le fonctionnement dudit circuit logique interne, ledit circuit logique interne comprenant une entrée (IN) et une sortie (OUT),
caractérisé en ce que ces moyens de test comprennent :
- un premier registre de test (4) ayant une entrée reliée à une première entrée (12) du circuit intégré et au moins une sortie reliée à l'entrée du circuit logique interne,
- un deuxième registre de test (6) ayant une entrée reliée à la sortie du circuit logique interne et une sortie reliée à une première sortie (16) du circuit intégré,
- une deuxième entrée (14) pour recevoir un signal d'horloge externe (TCK) pour piloter, d'une part, la fourniture au premier registre de test (4) d'au moins un motif de test reçu sur la première entrée (12), ledit motif de test étant formé d'un ensemble d'états logiques et, d'autre part, la fourniture à la première sortie (16) d'au moins un motif résultant mémorisé dans le deuxième registre de test (6), ce motif résultant étant produit sur la sortie du circuit logique interne quand on fournit le motif de test à l'entrée dudit circuit logique interne,
- un circuit générateur de signal d'horloge (18) pour produire un signal d'horloge interne (CKFAST), et
- un circuit de contrôle (20) pour produire, à partir du signal d'horloge interne, un signal d'horloge de test (LCCK) permettant de piloter la fourniture du motif de test à l'entrée du circuit logique interne et la fourniture du motif résultant à l'entrée du deuxième registre de test.

7. Circuit selon la revendication 6, comprenant une deuxième sortie (26), caractérisé en ce que les moyens de test comprennent un circuit diviseur de fréquence (24) recevant le signal d'horloge interne et produisant un signal d'horloge interne dérivé (OCK), de fréquence inférieure à celle du signal d'horloge interne, ladite fréquence inférieure étant représentative de la fréquence du signal d'horloge interne, et ledit signal d'horloge interne dérivé étant fourni à la deuxième sortie (26) du circuit intégré.

8. Circuit selon l'une des revendications 6 ou 7, caractérisé en ce que le circuit générateur de signal d'horloge (18) comprend un premier circuit de retard programmable (70) pour produire un retard programmable et des circuits logiques (74, 82) permettant de réaliser un oscillateur en anneau programmable par rebouclage d'une entrée (54) et d'une sortie (56) du premier circuit à retard (70).

9. Circuit selon la revendication 8, le premier circuit à retard (70) du circuit générateur de signal d'horloge (18) produisant un signal (C) carré de fréquence programmable, caractérisé en ce que le circuit générateur de signal d'horloge comprend un deuxième circuit de retard programmable (86) recevant le signal carré et produisant un signal carré retardé (G), une porte logique (92) produisant un signal d'horloge intermédiaire (J) à partir d'une combinaison du signal carré et du signal carré retardé, de sorte que le signal intermédiaire a un rapport cyclique programmable, et des moyens (94, 96, 102) pour produire le signal d'horloge interne (CKFAST) à partir du signal d'horloge intermédiaire.

10. Circuit selon l'une des revendications 6 à 9, caractérisé en ce qu'il comprend un circuit de conversion parallèle/série (8) placé entre le premier registre de test (4) et l'entrée (IN) du circuit logique interne et en ce que le circuit de contrôle (20) produit un ou des signaux de sélection (PHASE0, PHASE1) pour piloter le circuit de conversion parallèle/série, lesdits signaux de sélection étant produits à partir du signal d'horloge interne (CKFAST).

11. Circuit selon la revendication 10, caractérisé en ce que le circuit de contrôle (20) comprend, d'une part, un circuit de production de signaux de pilotage (201) pour produire un signal d'horloge filtré (CK5) et des signaux de sélection primaires (P0, P1) et, d'autre part, des circuits de déphasage (202, 203) recevant le signal d'horloge filtré et les signaux de sélection primaires, ces circuits de déphasage comprenant des circuits à retard (114, 126) programmables pour produire, à partir des signaux reçus, les signaux de sélection pilotant le circuit de conversion parallèle/série et le signal d'horloge de test, lesdits signaux de sélection pilotant le circuit de conversion parallèle/série étant déphasés temporellement par rapport au signal d'horloge de test.

12. Circuit selon les revendications 6 à 11, caractérisé en ce que le circuit de contrôle (20) comprend des moyens de filtrage (201) pour produire, à partir du signal d'horloge interne (CKFAST), dans un mode de test dit en rafale, le signal d'horloge de test (LCCK) pilotant le fonctionnement du circuit logique interne, ce signal d'horloge de test comprenant au moins un train d'impulsion comprenant un nombre d'impulsions déterminé.

13. Circuit selon la revendication 12, caractérisé en ce que le circuit de contrôle (20) fournit un signal logique (BURSTOK) représentatif de la durée de trains d'impulsions dans le mode de test en rafale.
